(19) Europäisches Patentamt
European Patent Office
Office européen des brevets

(11) EP 0 778 996 B1

(12) # EUROPÄISCHE PATENTSCHRIFT

(45) Veröffentlichungstag und Bekanntmachung des Hinweises auf die Patenterteilung:
**06.05.1999 Patentblatt 1999/18**

(21) Anmeldenummer: **95928974.5**

(22) Anmeldetag: **24.08.1995**

(51) Int Cl.6: **H03D 3/00**

(86) Internationale Anmeldenummer:
**PCT/DE95/01125**

(87) Internationale Veröffentlichungsnummer:
**WO 96/07235 (07.03.1996 Gazette 1996/11)**

(54) **VERFAHREN UND VORRICHTUNG ZUR ENTZERRUNG VON SIGNALPAAREN**

PROCESS AND DEVICE FOR RESHAPING PAIRS OF SIGNALS

PROCEDE ET DISPOSITIF PERMETTANT DE REMETTRE EN FORME DES PAIRES DE SIGNAUX

(84) Benannte Vertragsstaaten:
**DK ES FR GB IT NL SE**

(30) Priorität: **29.08.1994 DE 4430679**

(43) Veröffentlichungstag der Anmeldung:
**18.06.1997 Patentblatt 1997/25**

(73) Patentinhaber: **SICAN, GESELLSCHAFT FÜR SILIZIUM-ANWENDUNGEN UND CAD/CAT NIEDERSACHSEN mbH**
**D-30419 Hannover (DE)**

(72) Erfinder: **BEHRENT, Hermann**
**D-22958 Kuddewörde (DE)**

(74) Vertreter: **Gerstein, Hans Joachim**
**Wilhelm-Busch-Strasse 2**
**30167 Hannover (DE)**

(56) Entgegenhaltungen:
**EP-A- 0 598 277**
**US-A- 5 165 051**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 778 996 B1

## Beschreibung

Die Erfindung betrifft ein Verfahren und eine Vorrichtung zur Entzerrung von Signalpaaren, die aus vektoriell darstellbaren Inphase- (I) und Quadratur-Signalen (Q) bestehen.

### Stand der Technik

Analoge oder digitale orthogonale Signalpaare finden insbesondere dort Verwendung, wo mittels eines einzigen Trägers gleichzeitig zwei Signale übertragen werden, beispielsweise beim Fernsehen mit der Farbträgermodulation beim PAL-Standard, oder bei der Vektormodulation, aber auch dort, wo Signalspektren in einem anderen Frequenzbereich umgesetzt werden, wie bei Funksignalen, der Verarbeitung von Radarsignalen und der Sonometrie. Das erfindungsgemäße Verfahren und die Vorrichtung ist dabei vorteilhaft auf die Entzerrung winkelmodulierter Signale anzuwenden.

Infolge nicht idealer, toleranzbehafteter Bauelemente entstehen lineare Verzerrungen des Basisbandsignals unter anderem durch Fehlanpassung der Amplituden und Phasen, Offsets des Gleichanteils und der Frequenz, sowie nichtlineare Verzerrungen durch Übersprechen und Intermodulation.

Abhilfe schaffen hier Korrekturschaltungen, die mittels geeigneter Detektoren systematische und statistische Fehler des orthogonalen Signalpaares erkennen und daraus Korrektursignale erzeugen, um die Fehler durch Rückkopplung auszuregeln.

In EP 473 373 wird ein Kalibrierungssystem für Homodynempfänger beschrieben, um den Phasenfehler im HF-Front-End auszuregeln. Das beschriebene System hat den Nachteil, daß der Betrieb zur Injektion eines Hilfsträgers intervallweise unterbrochen wird und sich das Referenzsignal von dem zu empfangenen Signal unterscheidet, so daß nur eine angenäherte Entzerrung der Phase erfolgt.

In EP 343 273 werden in einem, dem HF-Front-End nachfolgenden Prozeß, alle oben genannten linearen Verzerrungen, mit Ausnahme des Frequenzoffsets erkannt und durch mehrfach unterlegte Rückkopplungen ausgeregelt. Der Nachteil dieses Verfahrens sind die Verkettung der Stellgrößen und des damit permanent erhöhten Regelbedarfs, sowie dem damit verbundenen Risiko der Instabilität. Diesem Stand der Technik ist eine separat und kommutativ getrennt voneinander durchführbare Entzerrung des DC-Offsets, des Amplituden- und Phasenfehlers zu entnehmen. Die Lösung basiert insofern auf einer Ausgleichungsrechnung, als Gleichanteile zur Berechnung von Korrekturwerten ermittelt werden.

In EP 595 278 wird die Ermittlung aller Fehlergrößen von I- und Q-Signalen bei Homodynempfängern durch eine Ausgleichsrechnung, z.B. mit einer linearen Regression (siehe I.O. Kerner "Bester Kegelschnitt durch n Punkte" ZAMM 59, S. 396-397, 1979), beansprucht. Der Nachteil dieses Verfahrens liegt in dem komplexen Rechenaufwand zur Lösung einer quadratischen Matrix für fünf unbekannte Ellipsenparameter, die im übrigen in der Patentschrift nicht offenbart ist.

Aus EP 598 277 und DE 39 38 643 ist ein Verfahren und eine Vorrichtung zur Offsetkorrektur bekannt. Dabei wird vorausgesetzt, daß die Entzerrung der Elliptizität zuvor erfolgt ist.

Zur Korrektur der Mittelpunktsverschiebung werden die Mittelpunktskoordinaten zweier in Quadratur stehender mittelpunktsverschobener I- und Q-Signale mittels Ausgleichungsrechnung so bestimmt, daß Schwerpunktslinien gebildet und ein gemeinsamer Schnittpunkt ermittelt wird. Hierzu wird eine Anzahl von Differenzen quadratischer Radien jeweils zweier aufeinanderfolgender Punkte minimiert und von den Signalen I und Q subtrahiert. Die Linearisierung und Minimierung der Funktion erfolgt ebenfalls nach 1.O. Kerner. Eine derartige Lösung weist aufgrund der endlichen Rechengenauigkeit von den ausführenden Rechenwerken eine vergleichsweise große Abweichung von den tatsächlichen Mittelpunkten auf. Insbesondere nehmen die Rundungsfehler mit wachsender Verzerrung stark zu.

In EP 595 277 wird die Frequenzablage des lokalen Oszillators bei Homodynempfängern beansprucht, welche eine überlagerte Rotation des Vektors bewirkt, der durch das orthogonale Signalpaar in der karthesischen 1-, Q-Ebene repräsentiert ist, so daß die Aufenthaltswahrscheinlichkeit der Vektorspitze auf den Umfang der Ellipse gleichmäßig verteilt ist.

In US-A-5,165,051 ist ein Verfahren und eine Vorrichtung zum Bestimmen der Amplitude, der Phase und der Frequenz eines Signalpaares beschrieben, das aus vektoriell darstellbaren Inphase- (I) und Quadratur-Signalen (Q) besteht. Mit der Methode der kleinsten Fehlerquadrate ("Least Square Estimation" - LMS) werden die Signalparameter aus Signalproben berechnet. Die LMS-Methode ist eine Ausgleichsrechnung mit geringem Rechenaufwand zum Herausfiltern der periodischen Schwingungen aus einem mit Rauschen überlagertem Signal. Mit den ermittelten Signalparametern des periodischen Signalanteils wird ein lokaler Oszillator gesteuert, dessen Signal dem Inphase-Signal (I) direkt und dem Quadratur-Signal (Q) mit einer Phasenverschiebung von 90° überlagert wird. Dadurch kann das Trägersignal zwar relativ genau bestimmt werden, es können aber nur zukünftige Signale korrigiert werden. Das aktuelle Signal, das zur Berechnung der Signalparameter verwendet wird, bleibt unverändert. Bei kontinuierlichen Signalen dürfte der Fehler dadurch zwar gering sein, doch durch die Rückkoppelung des Signals besteht die Gefahr von Restschwingungen des Systems.

Aufgabe

Aufgabe der Erfindung war es, ein Verfahren und eine Vorrichtung zur Entzerrung von Signalpaaren, die aus vektoriell darstellbaren Inphase- (I) und Quadratur-Signalen (Q) bestehen, anzugeben. Die Korrekturwerte sollten dabei mittels Ausgleichsrechnung unter Verwendung von Signalproben aus dem Signalstrom berechnet werden. Um Restschwingungen zu vermeiden, sollte die Korrektur nicht mit einem rückgekoppelten System durchgeführt werden. Bei dem Verfahren sollte der Rechenaufwand möglichst gering gehalten werden.

Erfindung

Die Erfindung, die durch die Ansprüche definiert ist, sieht nun zur Lösung dieser Aufgabe vor, daß nach vorangegangener Korrektur der Mittelpunktsverschiebung die korrektur der Amplitudenfehler $\alpha$ und der Phasenfehler $\delta$ durchgeführt wird. Diese Parameter können mit der Matrixgleichung

$$\begin{bmatrix} \alpha^2 \\ -2\cdot\alpha\cdot\sin(\delta) \\ -r^2\cdot\delta^2\cdot\cos^2(\delta) \end{bmatrix} = \begin{bmatrix} \sum_{k=1}^{p}(Q'_k)^4 & \sum_{k=1}^{p}I'_k\cdot(Q'_k)^3 & \sum_{k=1}^{p}(Q'_k)^2 \\ \sum_{k=1}^{p}I'_k\cdot(Q'_k)^3 & \sum_{k=1}^{p}(I'_k)^2\cdot(Q'_k)^2 & \sum_{k=1}^{p}I'_k\cdot Q'_k \\ \sum_{k=1}^{p}(Q'_k)^2 & \sum_{k=1}^{p}I'_k\cdot Q'_k & p \end{bmatrix}^{-1} \cdot \begin{bmatrix} -\sum_{k=1}^{p}(I'_k)^2\cdot(Q'_k)^2 \\ -\sum_{k=1}^{p}(I'_k)^3\cdot Q'_k \\ -\sum_{k=1}^{p}(I'_k)^2 \end{bmatrix} \quad (1)$$

berechnet werden, wobei mindestens jeweils drei Signalproben $I'_k$ und $Q'_k$ dem Signalstrom entnommen werden, die bereits einer Mittelpunktsverschiebung unterzogen wurden.

Erfindungsgemäß basiert das Gleichungssystem zur Korrektur des Amplitudenfehlers $\alpha$ und des Phasenfehlers $\delta$ auf einer im Ursprung zentrierten Kreisgleichung und deren Umformung zur Ellipsengleichung unter Beibehaltung eines der Signale I- oder Q als Referenzsignal. Die Mindestanzahl von drei Signalproben $Q'_k$ und $I'_k$ (n, p $\geq$ 3) ergibt sich hierbei aus der Notwendigkeit der mathematischen Bestimmtheit der Gleichungssysteme.

Der Rechenaufwand konnte sowohl durch die Trennung und die Reihenfolge der Verfahren (erst die Berechnung der Mittelpunktsverschiebung und dann die Berechnung der Amplituden- und Phasenfehler), als auch durch die Reduzierung der Gleichungssysteme stark minimiert werden. Dabei kann die beanspruchte Form der Ausgleichsrechnung nur durch die, in Verbindung mit der Ausgleichsrechnung erfinderische Trennung und Reihenfolge der Verfahren, eingesetzt werden.

Für die Mittelpunktskorrektur sind verschiedene Verfahren denkbar. Im Vergleich zu der Berechnung der Ellipsenparameter muß die Mittelpunktsverschiebung weniger häufig berechnet werden, da sich dieser Störfaktor nur über einen längeren Zeitraum ändert. Daher muß die Ermittlung der Mittelpunktsverschiebung weniger häufig durchgeführt werden, so daß es hierbei zur Minimierung des Rechenaufwands nicht in dem Maße auf die optimale Lösung ankommt, wie bei dem Verfahren zur Berechnung der Amplituden- und Phasenfehler.

Besonders vorteilhaft ist die Kombination mit einem weiteren neuen Ansatz für die Ermittlung der Mittelpunktsverschiebung. Hierbei wird eine Kreisgleichung umgeformt und linearisiert. Die Kreisparameter werden derart optimiert, daß ein resultierender Kreis optimal in die Schar ellipsenförmig angeordneter Abtastwerte eingepaßt ist. Die Mittelpunktsverschiebung wird dann durch die Matrixgleichung

$$\begin{bmatrix} Qm \\ Im \\ H \end{bmatrix} = \begin{bmatrix} 2\sum_{l=1}^{n}(Q_l)^2 & 2\sum_{l=1}^{n}(I_l \cdot Q_l) & -\sum_{l=1}^{n}Q_l \\ 2\sum_{l=1}^{n}(I_l \cdot Q_l) & 2\sum_{l=1}^{n}(I_l)^2 & -\sum_{l=1}^{n}I_l \\ -2\sum_{l=1}^{n}Q_l & -2\sum_{l=1}^{n}I_l & n \end{bmatrix}^{-1} \cdot \begin{bmatrix} -\sum_{l=1}^{n}\left[(Q_l)^3 + (I_l)^2 \cdot Q_l\right] \\ -\sum_{l=1}^{n}\left[I_l \cdot (Q_l)^2 + (I_l)^3\right] \\ \sum_{l=1}^{n}\left[(Q_l)^2 + (I_l)^2\right] \end{bmatrix} \quad (2)$$

mit Signalproben $I_1$ aus dem unkorrigierten Signalstrom des Inphase-Signals (I) und mit Signalproben $Q_1$ aus dem unkorrigierten Signalstrom des Quadratur-Signals (Q) berechnet. Durch die Verwendung dieses 3x3-Gleichungssystems kann der Rechenaufwand erheblich minimiert werden.

Dadurch, daß die Mittelpunktsverschiebung bereits vor dem Amplituden- / Phasenfehler kompensiert wird, ist die Größenordnung der Werte erheblich kleiner und liegt immer in einem vorhersagbaren Bereich. Die Bitbreite und der damit verbundene Aufwand für die Rechenwerke kann dadurch bei gleicher Genauigkeit geringer gehalten werden. Außerdem wird die resultierende Signalqualität wesentlich verbessert.

Zum Vergleich mit dem in EP 598 277 beschriebenen Verfahren, bei denen die Ellipse zunächst gekippt und anschließend zum Kreis entzerrt wird, konnte durch die Erfindung eine deutliche Qualitätsverbesserung erzielt werden. Die Verfahren unterscheiden sich grundlegend dahingehend, daß bei der Erfindung die Ausgleichsrechnung nicht für die Ermittlung eines Schnittpunktes, sondern für die Berechnung der Koeffizienten eines optimal angepaßten Kreises verwendet wird.

Die technische Ausführung der Vorrichtung nach Anspruch ist durch das Gleichungssystem festgelegt. Der Aufbau einer konkreten Vorrichtung nach den Ansprüchen 5 bis 8 ist dem Fachmann ohne weiteres mittels eines digitalen Signalprozessors oder einer anwendungsorienten integrierten Schaltung (ASIC) möglich.

Ausführungsbeispiele

Die Erfindung wird im folgenden anhand der Figuren näher erläutert:

Fig. 1 zeigt in Form eines Blockschaltbildes die Erzeugung der verzerrten I- und Q-Signale (3,4) z.B. durch ein HF-Front-End-Modul (2) eines Homodynempfängers aus dem Eingangssignal (1) und eine Vorrichtung zur Entzerrung (7) mit den korrigierten Signalen (5,6), I" und Q"

Fig. 2 zeigt als Signalflußdiagramm die Korrektur des Gleichanteil-Offsets in allgemeingültiger Form mit dem Rechenwerk (9) zur Bestimmung des Mittelpunktes Qm und Im.

Fig. 3 zeigt als Signalflußdiagramm die Korrektur der Elliptizität in allgemeingültiger Form mit dem Rechenwerk (11) zur Bestimmung der Korrekturkoeffizienten.

In der Fig. 1 ist als Beispiel ein Homodynempfänger (2) gezeigt. Das von einer Antenne kommende Eingangssignal (1) wird verstärkt und in zwei Mischern mit dem orthogonalen Signalpaar eines lokalen Oszillators überlagert. Die Oszillatorfrequenz liegt dabei in dem zu empfangenen Spektrum. Die unerwünschten Mischprodukte, die in dem niederfrequenten Bereich entstehen, werden durch Filter getrennt. Der Erfindung liegt die Erkenntnis zugrunde, daß das derart erzeugte orthogonale niederfrequente Signalpaar (3,4) durch einen rotierenden Vektor in der karthesischen I-, Q-Ebene repräsentiert wird. Mit einer reinen Winkelmodulation liegt die Vektorspitze des unverzerrten und ungestörten Signalpaares auf einem Kreis, dessen Mittelpunkt mit dem Ursprung der karthesischen I-, Q-Ebene übereinstimmt. Durch die zuvor beschriebenen linearen Verzerrungen wird der Kreismittelpunkt aus dem Ursprung verlagert und der Kreis zu einer Ellipse verzerrt.

In der Fig. 2 ist der Signalfluß zur Entfernung der Verzerrung durch den Gleichanteil-Offset dargestellt. Der Gleichanteil-Offset wird durch eine Ursprungsverschiebung des rotierenden Vektors in der karthesischen I-, Q-Ebene repräsentiert, so daß zur Korrektur des Offsets der Mittelpunkt dieses elliptischen I-, Q-Signals bestimmt werden muß. Die Erfindung sieht vor, diesen Mittelpunkt durch Ausgleichsrechnung im Rechenwerk (9) für einen Kreis anstelle einer Ellipse aus Proben des gemessenen I- und Q-Signals zu ermitteln. Dieses Vorgehen ist insbesondere dann sehr genau, wenn durch den eingangs erwähnten Frequenz-Offset des lokalen Oszillators eine überlagerte Rotation des Vektors eingebracht wird und dadurch die Aufenthaltswahrscheinlichkeit der Vektorspitze auf dem Ellipsenumfang gleichverteilt ist. Durch Subtraktion des Mittelpunkts vom gemessenen I- und Q-Signal (3,4) wird der verzerrende Gleichanteil-Offset entfernt.

In der Fig. 3 ist der Signalfluß zur Entzerrung der Elliptizität dargestellt. Die Ellipsenparameter werden aus Proben des vom Gleichanteil-Offset befreiten I-und Q-Signals durch Ausgleichsrechnung im Rechenwerk (11) bestimmt und die elliptische Verzerrung rückgängig gemacht. Damit stehen die linear entzerrten 1-und Q-Signale (5,6) zur weiteren Verarbeitung bereit.

Die Verfahren zur Korrektur des Gleichanteil-Offsets und der elliptischen Verzerrung mit der Methode der Ausgleichsrechnung können voneinander unabhängig durchgeführt werden, weil die Bestimmung des Gleichanteil-Offsets durch die Annahme eines optimal eingepaßten Kreises zulässig ist. Dadurch, daß zuerst die Entfernung des Gleichanteil-Offsets und anschließend die Korrektur der Elliptizität erfolgt, kann der Rechenaufwand reduziert werden. Wenn alle Korrekturwerte mit einer einzigen Ausgleichsrechnung unter Anwendung der linearen Regression bestimmt werden, dann muß ein Gleichungssystem mit einer 5x5-Matrix aufgelöst werden. Mit der erfindungsgemäßen Aufteilung und Anordnung der Korrekturverfahren wird der Rechenaufwand auf die Lösung von zwei unabhängigen Gleichungssystemen mit je einer 3x3-Matrix reduziert und der Rundungsfehler minimiert. Bei der Auflösung des Gleichungssystems mit der 3x3-Matrix zur Bestimmung des Gleichanteil-Offsets fällt ein Hilfswert (H) ab, der proportional der Signalleistung ist.

Dieses ist ein weiterer Vorteil des Verfahrens, da ohne besondere zusätzliche Maßnahme die Signalleistung gemessen werden kann, welche eine unverzichtbare Größe in modernen Kommunikationsgeräten darstellt.

Ein Beispiel für das Verfahren zur Korrektur des Gleichanteil-Offsets ist in Fig. 2 dargestellt und wird im folgenden beschrieben:

Der Ansatz für die Aufstellung der Matrix (Gleichung 2) zur Durchführung einer linearen Regression ist eine allgemeingültige Kreisgleichung (Gleichung 3) und deren Umformung (Gleichung 4).

$$r^2 = (Q-Qm)^2 + (I-Im)^2 \qquad (3)$$

$$0 = Q^2 + I^2 - 2 \cdot Q \cdot Qm - 2 \cdot I \cdot Im + H \qquad (4)$$

Die Summen werden jeweils aus I Proben von Signalwertepaaren berechnet, wobei die Proben aus einem zusammenhängenden Zeitintervall entnommen werden, indem eine Änderung der zu bestimmenden Parameter vernachlässigbar klein erscheint.

Der Gleichanteil-Offset ist durch den Kreismittelpunkt Qm und Im gekennzeichnet. Mit der Hilfsgröße H kann die Signalleistung, der **R**adio-**S**ignal-**S**trength-**I**ndicator RSSI, durch Gleichung 5 bestimmt werden.

$$RSSI = Qm + Im - H \qquad (5)$$

In der Fig. 2 wird ferner dargestellt, wie durch Subtraktion der Korrekturgrößen Im und Qm vom gemessenen I- und Q-Signal der Gleichanteil-Offset entfernt wird. Das entspricht der Verlagerung des Ellipsenmittelpunktes in den Ursprung der karthesischen I-, Q-Ebene.

Der nachfolgende Ausgleich der Elliptizität wird durch die Tatsache vereinfacht, daß der Ellipsenmittelpunkt im Koordinatenursprung liegt.

Ein Beispiel für das erfindungsgemäße Verfahren zur Korrektur der Elliptizität ist in Fig. 3 dargestellt und wird im folgenden beschrieben:

Der Ansatz zur Aufstellung der Matrix (Gleichung 1) für die Durchführung der linearen Regression ist eine im Ursprung zentrierte Kreisgleichung (Gleichung 6) und deren Umformung (Gleichung 7). Das Q'-Signal wird als Referenzsignal beibehalten.

Das in Gleichung 6 orthogonal zum Q'-Signal angesetzte I'-Signal wird durch gemessene I'- und Q'-Signale substituiert, so daß das Amplitudenverhältnis $\alpha$ und der Phasenfehler $\delta$ in das Gleichungssystem einfließen. Gleichwertig ist ein entsprechender Ansatz unter Beibehaltung des I'-Signals als Referenzsignal.

$$r^2 = Q'^2 + I'^2 \qquad (6)$$

$$0 = Q'^2 + \left(\frac{I' - \alpha \cdot Q' \cdot \sin(\delta)}{\alpha \cdot \cos(\delta)}\right)^2 - r^2 \qquad (7)$$

Die Summen werden jeweils aus k Proben von Signalwertepaaren berechnet, wobei die Proben aus einem

zusammenhängenden Zeitintervall entnommen werden, indem eine Änderung der hier gesuchten Parameter vernachlässigbar klein erscheint.

Mit dem unteren Vektorelement aus Gleichung (2) kann die Signalleistung, der **R**adio-**S**ignal-**S**trength-**I**ndicator RSSI ($r^2$) bestimmt werden.

**Patentansprüche**

1. Verfahren zur Entzerrung von Signalpaaren, die aus vektoriell darstellbaren Inphase- (I) und Quadratur-Signalen (Q) bestehen, bei dem die Korrekturwerte mittels Ausgleichs rechnung unter Verwendung von Signalproben $I'_k$ aus dem Signalstrom des Inphase-Signals (I) und von Signalproben $Q'_k$ aus dem Signalstrom des Quadratur-Signals (Q) berechnet werden und damit eine Korrektur des Signals durchgeführt wird, dadurch gekennzeichnet, daß die Berechnung und Korrektur des Amplitudenfehlers a und des Phasenfehlers $\delta$ erst nach vorangegangener Korrektur der Mittelpunktsverschiebung mit Signalproben $I'_k$ und $Q'_k$ durchgeführt wird, die bereits einer Korrektur der Mittelpunktsverschiebung unterzogen wurden.

2. Verfahren nach Anspruch 1, dadurch gekennzeichnet, daß der Amplitudenfehler a und der Phasenfehler $\delta$ mittels der Matrixgleichung

$$\begin{bmatrix} \alpha^2 \\ -2\cdot\alpha\cdot\sin(\delta) \\ -r^2\cdot\delta^2\cdot\cos^2(\delta) \end{bmatrix} = \begin{bmatrix} \sum_{k=1}^{p}(Q'_k)^4 & \sum_{k=1}^{p}I'_k\cdot(Q'_k)^3 & \sum_{k=1}^{p}(Q'_k)^2 \\ \sum_{k=1}^{p}I'_k\cdot(Q'_k)^3 & \sum_{k=1}^{p}(I'_k)^2\cdot(Q'_k)^2 & \sum_{k=1}^{p}I'_k\cdot Q'_k \\ \sum_{k=1}^{p}(Q'_k)^2 & \sum_{k=1}^{p}I'_k\cdot Q'_k & p \end{bmatrix}^{-1} \cdot \begin{bmatrix} -\sum_{k=1}^{p}(I'_k)^2\cdot(Q'_k)^2 \\ -\sum_{k=1}^{p}(I'_k)^3\cdot Q'_k \\ -\sum_{k=1}^{p}(I'_k)^2 \end{bmatrix}$$

berechnet wird, wobei r der Radius des durch die vektoriell dargestellten Signalproben $I'_k$ und $Q'_k$ gebildeten Kreises und p die Anzahl der zur Berechnung der Matrixgleichung dem Signalstrom entnommenen Signalproben ist und wobei mindestens jeweils drei Signalproben $Q'_k$ und $I'_k$ dem Signalstrom entnommen werden.

3. Verfahren nach Anspruch 1 oder 2, dadurch gekennzeichnet, daß die Korrekturwerte Im und Qm der Mittelpunktsverschiebung mit Signalproben $I_1$ aus dem unkorrigierten Signalstrom des Inphase-Signals (I) und mit Signalproben $Q_1$ aus dem unkorrigierten Signalstrom des Quadratur-Signals (Q) mittels der Matrixgleichung

$$\begin{bmatrix} Qm \\ Im \\ H \end{bmatrix} = \begin{bmatrix} 2\sum_{l=1}^{n}(Q_l)^2 & 2\sum_{l=1}^{n}(I_l\cdot Q_l) & -\sum_{l=1}^{n}Q_l \\ 2\sum_{l=1}^{n}(I_l\cdot Q_l) & 2\sum_{l=1}^{n}(I_l)^2 & -\sum_{l=1}^{n}I_l \\ -2\sum_{l=1}^{n}Q_l & -2\sum_{l=1}^{n}I_l & n \end{bmatrix}^{-1} \cdot \begin{bmatrix} -\sum_{l=1}^{n}\left[(Q_l)^3+(I_l)^2\cdot Q_l\right] \\ -\sum_{l=1}^{n}\left[I_l\cdot(Q_l)^2+(I_l)^3\right] \\ \sum_{l=1}^{n}\left[(Q_l)^2+(I_l)^2\right] \end{bmatrix}$$

bestimmt werden, wobei H ein zur Signalleistung proportionaler Wert und n die Anzahl der zur Berechnung der Matrixgleichung dem Signalstrom entnommenen Signalproben ist und wobei mindestens jeweils drei Signalproben $Q_1$ und $I_1$ dem Signalstrom entnommen werden.

4. Verfahren nach einem der vorhergehenden Ansprüche zur Entzerrung von Signalen eines Homodynempfängers.

5. Vorrichtung zur Entzerrung von Signalpaaren, die als Inphase- (I) und Quadratur-Signale (Q) vektoriell darstellbar sind, bestehend aus einem Rechenwerk (8) zur Berechnung und Korrektur der Mittelpunktsverschiebung und einem Rechenwerk (10) zur Berechnung und Korrektur des Amplitudenfehlers $\alpha$ sowie des Phasenfehlers $\delta$ mittels

einer Ausgleichsrechnung unter Verwendung von Signalproben $I'_k$ aus dem Signalstrom des Inphase-Signals (I) und von Signalproben $Q'_k$ aus dem Signalstrom des Quadratur-Signals (Q), dadurch gekennzeichnet, daß das Rechenwerk (8) zur Berechnung und Korrektur der Mittelpunktsverschiebung dem Rechenwerk (10) zur Berechnung und Korrektur des Amplitudenfehlers $\alpha$ und des Phasenfehlers $\delta$ vorgeschaltet ist und die Berechnung des Amplitudenfehlers $\alpha$ und des Phasenfehlers $\delta$ mit Signalproben $I'_k$ und $Q'_k$ durchgeführt wird, die bereits einer Korrektur der Mittelpunktsverschiebung unterzogen wurden.

6. Vorrichtung nach Anspruch 5, dadurch gekennzeichnet, daß das Rechenwerk (10) zur Berechnung des Amplitudenfehlers $\alpha$ und des Phasenfehlers $\delta$ mittels Berechnung der Matrixgleichung

$$\begin{bmatrix} \alpha^2 \\ -2\cdot\alpha\cdot\sin(\delta) \\ -r^2\cdot\delta^2\cdot\cos^2(\delta) \end{bmatrix} = \begin{bmatrix} \sum_{k=1}^{p}(Q'_k)^4 & \sum_{k=1}^{p}I'_k\cdot(Q'_k)^3 & \sum_{k=1}^{p}(Q'_k)^2 \\ \sum_{k=1}^{p}I'_k\cdot(Q'_k)^3 & \sum_{k=1}^{p}(I'_k)^2\cdot(Q'_k)^2 & \sum_{k=1}^{p}I'_k\cdot Q'_k \\ \sum_{k=1}^{p}(Q'_k)^2 & \sum_{k=1}^{p}I'_k\cdot Q'_k & p \end{bmatrix}^{-1} \begin{bmatrix} -\sum_{k=1}^{p}(I'_k)^2\cdot(Q'_k)^2 \\ -\sum_{k=1}^{p}(I'_k)^3\cdot Q'_k \\ -\sum_{k=1}^{p}(I'_k)^2 \end{bmatrix}$$

ausgebildet ist, wobei r der Radius des durch die vektoriell dargestellten Signalproben $I'_k$ und $Q'_k$ gebildeten Kreises und p die Anzahl der zur Berechnung der Matrixgleichung dem Signalstrom entnommenen Signalproben ist und wobei mindestens jeweils drei Signalproben $Q'_k$ und $I'_k$ dem Signalstrom entnommen werden.

7. Vorrichtung nach Anspruch 5 oder 6, dadurch gekennzeichnet, daß das Rechenwerk (8) zur Berechnung der Korrekturwerte Im und Qm der Mittelpunktsverschiebung mit Signalproben $I_1$ aus dem unkorrigierten Signalstrom des Inphase-Signals (I) und mit Signalproben $Q_1$ aus dem unkorrigierten Signalstrom des Quadratur-Signals (Q) durch die Matrixgleichung

$$\begin{bmatrix} Qm \\ Im \\ H \end{bmatrix} = \begin{bmatrix} 2\sum_{l=1}^{n}(Q_l)^2 & 2\sum_{l=1}^{n}(I_l\cdot Q_l) & -\sum_{l=1}^{n}Q_l \\ 2\sum_{l=1}^{n}(I_l\cdot Q_l) & 2\sum_{l=1}^{n}(I_l)^2 & -\sum_{l=1}^{n}I_l \\ -2\sum_{l=1}^{n}Q_l & -2\sum_{l=1}^{n}I_l & n \end{bmatrix}^{-1} \cdot \begin{bmatrix} -\sum_{l=1}^{n}\left[(Q_l)^3+(I_l)^2\cdot Q_l\right] \\ -\sum_{l=1}^{n}\left[I_l\cdot(Q_l)^2+(I_l)^3\right] \\ \sum_{l=1}^{n}\left[(Q_l)^2+(I_l)^2\right] \end{bmatrix}$$

ausgeprägt ist, wobei H ein zur Signalleistung proportionaler Wert und n die Anzahl der zur Berechnung der Matrixgleichung dem Signalstrom entnommenen Signalproben ist und wobei mindestens jeweils drei Signalproben $Q_1$ und $I_1$ dem Signalstrom entnommen werden.

8. Vorrichtung nach Anspruch 7, dadurch gekennzeichnet, daß das Rechenwerk (8) zur Berechnung der Korrekturwerte Im und Qm der Mittelpunktsverschiebung zur Ausgabe der mit dem Wert H proportionalen Signalleistung ausgeprägt ist.

9. Vorrichtung nach einem der Ansprüche 5 bis 8 zur Entzerrung von Signalen eines Homodynempfängers.

## Claims

1. A method of correcting distortion of pairs of signals consisting of in-phase signals (I) and quadrature signals (Q) which can be represented vectorially, in which method the correction values are calculated by a balancing calculation using signal samples $I'_k$ from the signal stream of the in-phase signal (I) and signal samples ($Q'_k$) from the

signal stream of the quadrature signal (Q) and correction of the signal is effected therewith, characterised in that the calculation and correction of the amplitude error α and of the phase error 6 is not carried out until after correction of the centre-point shift with signal samples $I'_k$ and $Q'_k$ which have already been subjected to a correction of the centre-point shift.

**2.** A method according to claim 1, characterised in that the amplitude error α and the phase error δ are calculated by means of the matrix equation

$$\begin{bmatrix} \alpha^2 \\ -2\cdot\alpha\cdot\sin(\delta) \\ -r^2\cdot\delta^2\cdot\cos^2(\delta) \end{bmatrix} = \begin{bmatrix} \sum_{k=1}^{p}(Q'_k)^4 & \sum_{k=1}^{p} I'_k\cdot(Q'_k)^3 & \sum_{k=1}^{p}(Q'_k)^2 \\ \sum_{k=1}^{p} I'_k\cdot(Q'_k)^3 & \sum_{k=1}^{p}(I'_k)^2\cdot(Q'_k)^2 & \sum_{k=1}^{p} I'_k\cdot Q'_k \\ \sum_{k=1}^{p}(Q'_k)^2 & \sum_{k=1}^{p} I'_k\cdot Q'_k & p \end{bmatrix}^{-1} \cdot \begin{bmatrix} -\sum_{k=1}^{p}(I'_k)^2\cdot(Q'_k)^2 \\ -\sum_{k=1}^{p}(I'_k)^3\cdot Q'_k \\ -\sum_{k=1}^{p}(I'_k)^2 \end{bmatrix}$$

where r is the radius of the circle formed by the vectorially represented signal samples $I'_k$ and $Q'_k$ and p is the number of signal samples taken from the signal stream for calculating the matrix equation and where at least three signal samples $Q'_k$ and $I'_k$ respectively are taken from the signal stream.

**3.** A method according to claim 1 or 2, characterised in that the correction values Im and Qm of the centre-point shift are determined with signal samples $I_1$ from the uncorrected signal stream of the in-phase signal (I) and with signal samples $Q_1$ from the uncorrected signal stream of the quadrature signal (Q) by means of the matrix equation

$$\begin{bmatrix} Qm \\ Im \\ H \end{bmatrix} = \begin{bmatrix} 2\sum_{1=1}^{n}(Q_1)^2 & 2\sum_{1=1}^{n}(I_1\cdot Q_1) & -\sum_{1=1}^{n}Q_1 \\ 2\sum_{1=1}^{n}(I_1\cdot Q_1) & 2\sum_{1=1}^{n}(I_1)^2 & -\sum_{1=1}^{n}I_1 \\ -2\sum_{1=1}^{n}Q_1 & -2\sum_{1=1}^{n}I_1 & n \end{bmatrix}^{-1} \cdot \begin{bmatrix} -\sum_{1=1}^{n}\left[(Q_1)^3+(I_1)^2\cdot Q_1\right] \\ -\sum_{1=1}^{n}\left[I_1\cdot(Q_1)^2+(I_1)^3\right] \\ \sum_{1=1}^{n}\left[(Q_1)^2+(I_1)^2\right] \end{bmatrix}$$

where H is a value proportional to the signal power and n is the number of signal samples taken from the signal stream for calculation of the matrix equation and wherein at least three signal samples $Q_1$ and $I_1$ are respectively taken from the signal stream.

**4.** A method according to any one of the preceding claims for correcting the distortion of signals in a homodyne receiver.

**5.** Apparatus for correcting distortion of signal pairs which can be represented victorially as in-phase signals (I) and quadrature signals (Q), consisting of a computer (8) for calculating and correcting the centre-point shift and a computer (10) for calculating and correcting the amplitude error α and the phase error δ by a balancing calculation using signal samples $I'_k$ from the signal stream of the in-phase signal (I) and signal samples $Q'_k$ from the signal stream of the quadrature signal (Q), characterised in that the computer (8) for calculating and correcting the centre-point shift precedes the computer (10) for calculating and correcting the amplitude error α and the phase error δ and the calculation of the amplitude error α and the phase error δ is performed with signal samples $I'_k$ and $Q'_k$ which have already been subjected to a correction of the centre-point shift.

**6.** Apparatus according to claim 5, characterised in that the computer (10) is designed to calculate the amplitude error α and the phase error δ by calculating the matrix equation

$$\begin{bmatrix} \alpha^2 \\ -2\cdot\alpha\cdot\sin(\delta) \\ -r^2\cdot\delta^2\cdot\cos^2(\delta) \end{bmatrix} = \begin{bmatrix} \sum_{k=1}^{p}(Q'_k)^4 & \sum_{k=1}^{p} I'_k\cdot(Q'_k)^3 & \sum_{k=1}^{p}(Q'_k)^2 \\ \sum_{k=1}^{p} I'_k\cdot(Q'_k)^3 & \sum_{k=1}^{p}(I'_k)^2\cdot(Q'_k)^2 & \sum_{k=1}^{p} I'_k\cdot Q'_k \\ \sum_{k=1}^{p}(Q'_k)^2 & \sum_{k=1}^{p} I'_k\cdot Q'_k & p \end{bmatrix}^{-1} \begin{bmatrix} -\sum_{k=1}^{p}(I'_k)^2\cdot(Q'_k)^2 \\ -\sum_{k=1}^{p}(I'_k)^3\cdot Q'_k \\ -\sum_{k=1}^{p}(I'_k)^2 \end{bmatrix}$$

where r is the radius of the circle formed by the vectorially represented signal samples $I'_k$ and $Q'_k$ and p is the number of signal samples taken from the signal stream for calculating the matrix equation and where at least three signal samples $Q'_k$ and $I'_k$ respectively are taken from the signal stream.

**7.** Apparatus according to claim 5 or 6, characterised in that the computer (8) is designed to calculate the correction values Im and Qm of the centre-point shift with signal samples $I_1$ from the uncorrected signal stream of the in-phase signal (I) and with signal samples $Q_1$ from the uncorrected signal stream of the quadrature signal (Q) by the matrix equation

$$\begin{bmatrix} Qm \\ Im \\ H \end{bmatrix} = \begin{bmatrix} 2\sum_{1=1}^{n}(Q_1)^2 & 2\sum_{1=1}^{n}(I_1\cdot Q_1) & -\sum_{1=1}^{n} Q_1 \\ 2\sum_{1=1}^{n}(I_1\cdot Q_1) & 2\sum_{1=1}^{n}(I_1)^2 & -\sum_{1=1}^{n} I_1 \\ -2\sum_{1=1}^{n} Q_1 & -2\sum_{1=1}^{n} I_1 & n \end{bmatrix}^{-1} \cdot \begin{bmatrix} -\sum_{1=1}^{n}\left[(Q_1)^3+(I_1)^2\cdot Q_1\right] \\ -\sum_{1=1}^{n}\left[I_1\cdot(Q_1)^2+(I_1)^3\right] \\ \sum_{1=1}^{n}\left[(Q_1)^2+(I_1)^2\right] \end{bmatrix}$$

where H is a value proportional to the signal power and n is the number of signal samples taken from the signal stream for calculation of the matrix equation and wherein at least three signal samples $Q_1$ and $I_1$ are respectively taken from the signal stream.

**8.** Apparatus according to claim 7, characterised in that the computer (8) for calculating the correction values Im and Qm of the centre point shift is adapted to output the signal power proportional to the value H.

**9.** Apparatus according to any one of claims 5 to 8 for correction of the distortion of signals of a homodyne receiver.

**Revendications**

**1.** Procédé pour corriger la distorsion de paires de signaux qui se composent de signaux en phase (I) et de signaux en quadrature (Q), pouvant être représentés sous forme vectorielle, selon lequel les valeurs de correction sont calculées par un calcul de compensation moyennant l'utilisation d'échantillons de signal $I'_k$, tirés du courant de signal du signal en phase (I), et d'échantillons de signal $Q'_k$, tirés du courant de signal du signal en quadrature (Q), et une correction du signal est effectuée à l'aide de ces valeurs de correction, caractérisé en ce que le calcul et la correction de l'erreur d'amplitude $\alpha$ et de l'erreur de phase $\delta$ ne sont effectués qu'après une correction préalable du décalage du point médian, à l'aide d'échantillons de signal $I'_k$ et $Q'_k$ qui ont déjà subi une correction du décalage du point médian.

**2.** Procédé selon la revendication 1, caractérisé en ce que l'erreur d'amplitude $\alpha$ et l'erreur de phase $\delta$ sont calculées au moyen de l'équation matricielle

$$\begin{bmatrix} \alpha^2 \\ -2\cdot\alpha\cdot\sin(\delta) \\ -r^2\cdot\delta^2\cdot\cos^2(\delta) \end{bmatrix} = \begin{bmatrix} \sum_{k=1}^{p}(Q'_k)^4 & \sum_{k=1}^{p}I'_k\cdot(Q'_k)^3 & \sum_{k=1}^{p}(Q'_k)^2 \\ \sum_{k=1}^{p}I'_k\cdot(Q'_k)^3 & \sum_{k=1}^{p}(I'_k)^2\cdot(Q'_k)^2 & \sum_{k=1}^{p}I'_k\cdot Q'_k \\ \sum_{k=1}^{p}(Q'_k)^2 & \sum_{k=1}^{p}I'_k\cdot Q'_k & p \end{bmatrix}^{-1} \cdot \begin{bmatrix} -\sum_{k=1}^{p}(I'_k)^2\cdot(Q'_k)^2 \\ -\sum_{k=1}^{p}(I'_k)^3\cdot Q'_k \\ -\sum_{k=1}^{p}(I'_k)^2 \end{bmatrix}$$

r étant le rayon du cercle formé par les échantillons de signal $I'_k$ et $Q'_k$, représentés sous forme vectorielle, et p, le nombre des échantillons de signal prélevés dans le courant de signal pour le calcul de l'équation matricielle, et au moins trois échantillons de signal $Q'_k$ et trois échantillons de signal $I'_k$ étant prélevés dans le courant de signal.

**3.** Procédé selon la revendication 1 ou 2, caractérisé en ce que les valeurs de correction Im et Qm du décalage du point médian à l'aide d'échantillons de signal $I_1$, tirés du courant de signal non corrigé du signal en phase (I), et à l'aide d'échantillons de signal $Q_1$, tirés du courant de signal non corrigé du signal en quadrature (Q), sont déterminées au moyen de l'équation matricielle

$$\begin{bmatrix} Qm \\ Im \\ H \end{bmatrix} = \begin{bmatrix} 2\sum_{l=1}^{n}(Q_l)^2 & 2\sum_{l=1}^{n}(I_l\cdot Q_l) & -\sum_{l=1}^{n}Q_l \\ 2\sum_{l=1}^{n}(I_l\cdot Q_l) & 2\sum_{l=1}^{n}(I_l)^2 & -\sum_{l=1}^{n}I_l \\ -2\sum_{l=1}^{n}Q_l & -2\sum_{l=1}^{n}I_l & n \end{bmatrix}^{-1} \cdot \begin{bmatrix} -\sum_{l=1}^{n}\left[(Q_l)^3+(I_l)^2\cdot Q_l\right] \\ -\sum_{l=1}^{n}\left[I_l\cdot(Q_l)^2+(I_l)^3\right] \\ \sum_{l=1}^{n}\left[(Q_l)^2+(I_l)^2\right] \end{bmatrix}$$

H étant une valeur proportionnelle à la puissance du signal et n, le nombre des échantillons de signal prélevés dans le courant de signal pour le calcul de l'équation matricielle, et au moins trois échantillons de signal $Q_1$ et trois échantillons de signal $I_1$ étant prélevés dans le courant de signal.

**4.** Procédé selon l'une des revendications précédentes pour corriger la distorsion de signaux d'un récepteur homodyne.

**5.** Dispositif pour corriger la distorsion de paires de signaux qui peuvent être représentées sous forme vectorielle en tant que signaux en phase (I) et signaux en quadrature (Q), constitué d'un calculateur (8) destiné au calcul et à la correction du décalage du point médian et d'un calculateur (10) destiné au calcul et à la correction de l'erreur d'amplitude *a* ainsi que de l'erreur de phase $\delta$ par un calcul de compensation, moyennant l'utilisation d'échantillons de signal I'k, tirés du courant de signal du signal en phase (I), et d'échantillons de signal $Q'_k$, tirés du courant de signal du signal en quadrature (Q), caractérisé en ce que le calculateur (8) destiné au calcul et à la correction du décalage du point médian est monté en amont du calculateur (10) destiné au calcul et à la correction de l'erreur d'amplitude $\alpha$ et de l'erreur de phase $\delta$, et le calcul de l'erreur d'amplitude $\alpha$ et de l'erreur de phase $\delta$ est effectué à l'aide d'échantillons de signal $I'_k$ et $Q'_k$ qui ont déjà subi une correction du décalage du point médian.

**6.** Dispositif selon la revendication 5, caractérisé en ce que le calculateur (10) destiné au calcul de l'erreur d'amplitude $\alpha$ et de l'erreur de phase $\delta$ est formé pour un calcul au moyen de l'équation matricielle

$$\begin{bmatrix} \alpha^2 \\ -2\cdot\alpha\cdot\sin(\delta) \\ -r^2\cdot\delta^2\cdot\cos^2(\delta) \end{bmatrix} = \begin{bmatrix} \sum_{k=1}^{p}(Q'_k)^4 & \sum_{k=1}^{p} I'_k\cdot(Q'_k)^3 & \sum_{k=1}^{p}(Q'_k)^2 \\ \sum_{k=1}^{p} I'_k\cdot(Q'_k)^3 & \sum_{k=1}^{p}(I'_k)^2\cdot(Q'_k)^2 & \sum_{k=1}^{p} I'_k\cdot Q'_k \\ \sum_{k=1}^{p}(Q'_k)^2 & \sum_{k=1}^{p} I'_k\cdot Q'_k & p \end{bmatrix}^{-1} \cdot \begin{bmatrix} -\sum_{k=1}^{p}(I'_k)^2\cdot(Q'_k)^2 \\ -\sum_{k=1}^{p}(I'_k)^3\cdot Q'_k \\ -\sum_{k=1}^{p}(I'_k)^2 \end{bmatrix}$$

r étant le rayon du cercle formé par les échantillons de signal $I'_k$ et $Q'_k$, représentés sous forme vectorielle, et p, le nombre des échantillons de signal prélevés dans le courant de signal pour le calcul de l'équation matricielle, au moins trois échantillons de signal $Q'_k$ et trois échantillons de signal $I'_k$ étant prélevés dans le courant de signal.

**7.** Dispositif selon la revendication 5 ou 6, caractérisé en ce que le calculateur (8) destiné au calcul des valeurs de correction Im et Qm du décalage du point médian, à l'aide d'échantillons de signal $I_1$ tirés du courant de signal non corrigé du signal en phase (I) et à l'aide d'échantillons de signal $Q_1$ tirés du courant de signal non corrigé du signal en quadrature (Q), est configuré pour un calcul au moyen de l'équation matricielle

$$\begin{bmatrix} Qm \\ Im \\ H \end{bmatrix} = \begin{bmatrix} 2\sum_{l=1}^{n}(Q_l)^2 & 2\sum_{l=1}^{n}(I_l\cdot Q_l) & -\sum_{l=1}^{n}Q_l \\ 2\sum_{l=1}^{n}(I_l\cdot Q_l) & 2\sum_{l=1}^{n}(I_l)^2 & -\sum_{l=1}^{n}I_l \\ -2\sum_{l=1}^{n}Q_l & -2\sum_{l=1}^{n}I_l & n \end{bmatrix}^{-1} \cdot \begin{bmatrix} -\sum_{l=1}^{n}\left[(Q_l)^3+(I_l)^2\cdot Q_l\right] \\ -\sum_{l=1}^{n}\left[I_l\cdot(Q_l)^2+(I_l)^3\right] \\ \sum_{l=1}^{n}\left[(Q_l)^2+(I_l)^2\right] \end{bmatrix}$$

H étant une valeur proportionnelle à la puissance du signal et n, le nombre des échantillons de signal prélevés dans le courant de signal pour le calcul de l'équation matricielle, et au moins trois échantillons de signal $Q_1$ et trois échantillons de signal $I_1$ étant prélevés dans le courant de signal.

**8.** Dispositif selon la revendication 7, caractérisé en ce que le calculateur (8), destiné au calcul des valeurs de correction Im et Qm du décalage du point médian, est configuré pour délivrer la puissance du signal proportionnelle à la valeur H.

**9.** Dispositif selon l'une des revendications 5 à 8 pour la correction de la distorsion de signaux d'un récepteur homodyne.

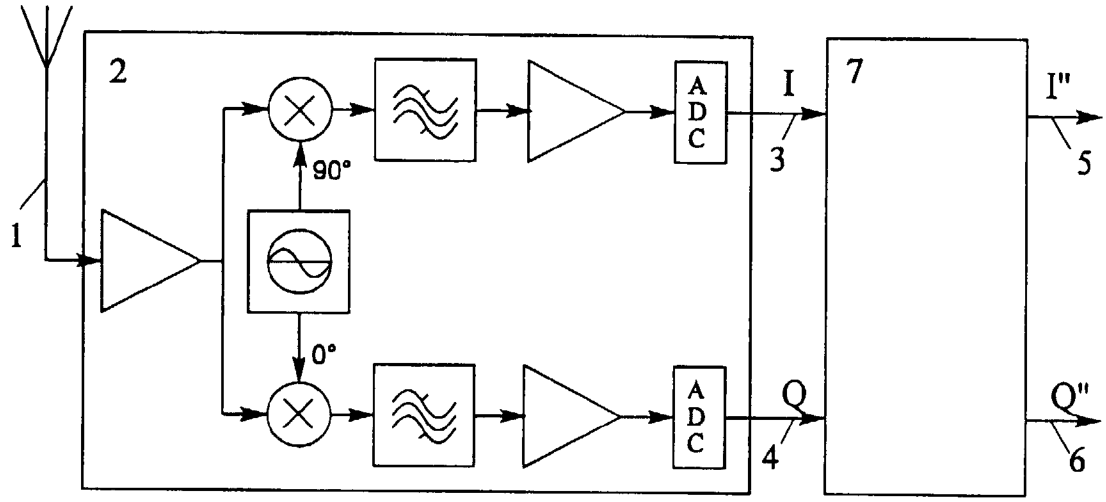


Fig. 1

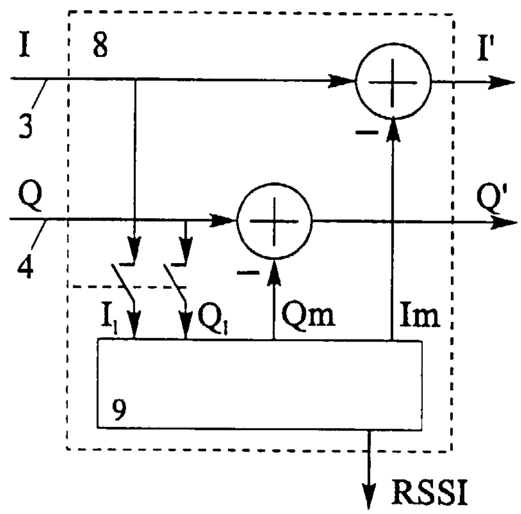


Fig. 2

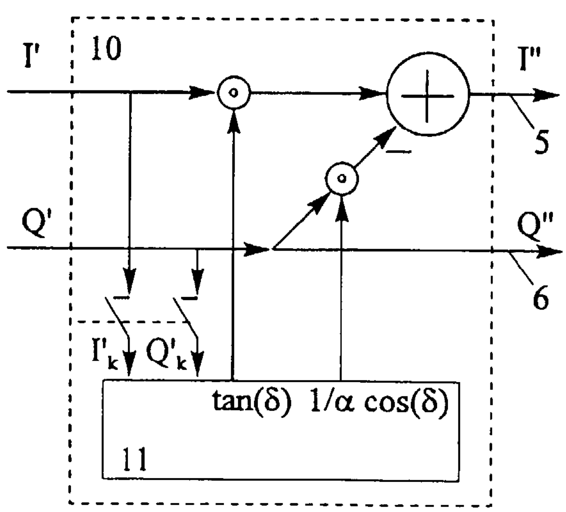


Fig. 3